# EUROPEAN PATENT APPLICATION

(11) **EP 2 862 903 A1**
(43) Date of publication of application: **22.04.2015**
(21) Application number: 13188809.1
(22) Date of filing: 16.10.2013
(51) Int. Cl.: C09D 4/00

(54) **A backsheet for photovoltaic modules**

(71) Applicant: AGFA-GEVAERT, 2640 Mortsel (BE)
(72) Inventor: Torfs, Rita, 2640 Mortsel (BE); Steenackers, Marin, 2640 Mortsel (BE)
(74) Representative: Viaene, Kris

(57) **Abstract**

A backsheet (1) for a photovoltaic module (5) comprising a support (10) and a weather resistant outerlayer provided on a side of the support characterized in that the weather resistant outerlayer comprises an at least partially cured coating from a curable composition wherein the curable composition comprises a monofunctional methacrylate and a difunctional (meth)acrylate monomer.

## Description

### FIELD OF THE INVENTION

The invention relates to a backsheet for a photovoltaic module and to a method to prepare such a backsheet.

### BACKGROUND OF THE INVENTION

With increasing energy prices and increasing concern over the scarcity and the environmental impact of hydrocarbon fuels, industry is turning to alternative energy sources, such as solar energy.

Photovoltaic (PV) modules, also known as solar modules, are used to produce electrical energy from sunlight. Such modules are based on a variety of semiconductor cell systems (the solar cell) that can absorb light and convert it into electrical energy.

In a typical PV module, the solar cell arrays are positioned between two encapsulant layers, which are further positioned between a front sheet (upper side of the module facing the incoming light) and a backsheet (back side of the module). The most widely used encapsulant is EVA, i.e. Ethylene Vinyl Acetate.

The backsheet provides weather resistance, UV resistance, moisture barrier properties, low dielectric constant and a high breakdown voltage to the solar cell module. To provide such properties to the PV module, a backsheet comprises a weather resistant film, for example a Tedlar™ film, and/or a polyethyleneterephthalate (PET) film. For example a TPT type backsheet, wherein a Tedlar™ film is laminated on both sides of a PET film, or a TPE type backsheet, wherein a Tedlar™ is laminated on one side of a PET film, while on the other side an encapsulant adhesion layer is provided, are nowadays widely used as backsheet on the market.

Instead of laminating a weather resistant sheet on a support it may be advantageous to coat a weather resistant layer on a support, for example to reduce the consumption of materials and energy. Such a weather resistant layer may be coated from an aqueous or a non-aqueous coating solution. US2009/0151774 for example discloses a backsheet wherein the weather resistant layer is coated on a plastic support instead of laminated.

A backsheet is typically laminated to a sealing layer, also referred to as encapsulant layer. For this reason, the adhesion of the backsheet to such a sealing layer has to be sufficiently good. To improve the adhesion, a primer may be provided on that side of a support facing the sealing layer.

### SUMMARY OF THE INVENTION

It is an object of the present invention to provide a backsheet for a photovoltaic module having optimal weathering properties.

The object of the invention is realized by the backsheet as defined in claim 1. It has been observed that for the backsheet according to claim 1 the adhesion of the weather resistant outer layer to the polymeric support is sufficient, even in the absence of a primer between the support and the outer layer.

It is another object of the invention to provide a method of preparing such a backsheet. That object is realized in the method as defined in claim 14.

Further advantages and embodiments of the present invention will become apparent from the following description and the dependent claims.

### BRIEF DESCRIPTION OF THE DRAWING

FIGURE 1 shows a schematic representation of an embodiment of a photovoltaic module according to the present invention.
FIGURE 2 shows a schematic representation of an embodiment of a backsheet according to the present invention.
FIGURE 3 shows a schematic representation of an embodiment of an "integrated" backsheet according to the present invention.

### DETAILED DESCRIPTION OF THE INVENTION

The backsheet (1) for a photovoltaic module (5) according to the present invention comprises a support (10) and a weather resistant outerlayer provided on a side of the support characterized in that the weather resistant outerlayer comprises an at least partially cured coating from a curable composition wherein the curable composition comprises a monofunctional methacrylate and a difunctional (meth)acrylate.

### The curable composition

The curable composition used to prepare the weather resistant outer layer comprises a monofunctional methacrylate and a difunctional (meth)acrylate. The curable composition preferably also comprises a polymerizable oligomer. The composition may further comprise an initiator, a polymerization inhibitor, compounds which decrease oxygen inhibition during polymerization, elastomers, surfactants, colorants, solvents, and/or humectants.

### Monofunctional methacrylate

The curable composition comprises a monofunctional methacrylate monomer. The amount of monofunctional methacrylate monomer is preferably between 5 and 40 wt %, more preferably between 10 and 30 wt %.

Any monofunctional methacrylate monomer, such as disclosed for example in EP-A 1637322, paragraph [0055], may be used.

The monofunctional methacrylate monomer is preferably selected from a tetrahydrofurfurylmethacrylate, a phenoxyethylmethacrylate, ethoxyethoxyethylmethacrylate, isobornylmethacrylate or mixtures thereof.

### Difunctional (meth)acrylate monomer

The curable composition comprises a difunctional (meth)acrylate monomer. The amount of difunctional (meth)acrylate monomer is preferably between 10 and 50 wt %, more preferably between 20 and 40 wt %.

A preferred difunctional (meth)acrylate monomer is a polyalkylene glycol di(meth)acrylate. Such compounds have two acrylate or methacrylate groups attached by an ester linkage at the opposite ends of a hydrophilic polyalkylene glycol.
Typically, the longer the length of the polyalkylene chain, the softer and more flexible the obtained layer after curing.

Examples of such polyalkylene glycol di(meth)acrylates include: 1,3-butylene glycol diacrylate, 1,3-butylene glycol dimethacrylate, diethylene glycol diacrylate, diethylene glycol dimethacrylate, dipropylene glycol diacrylate, ethylene glycol dimethacrylate, polyethylene glycol (200) diacrylate, polyethylene glycol (400) diacrylate, polyethylene glycol (400) dimethacrylate, polyethylene glycol (600) diacrylate, polyethylene glycol (600) dimethacrylate, polyethylene glycol dimethacrylate, polypropylene glycol (400) dimethacrylate, tetraethylene glycol diacrylate, tetraethylene glycol dimethacrylate, triethylene glycol diacrylate, triethylene glycol dimethacrylate, tripropylene glycol diacrylate, tripropylene glycol diacrylate, and combinations thereof. The number between brackets in the above list refers to the average Molecular Weight (MW) of the polyalkylene chain.

Highly preferred polyalkylene glycol diacrylates are polyethylene glycol diacrylates. Specific examples of commercially available polyethylene glycol diacrylate monomers include SR259 [polyethylene glycol (200) diacrylate], SR344 [polyethylene glycol (400) diacrylate], SR603 [polyethylene glycol (400) dimethacrylate], SR610 [polyethylene glycol (600) diacrylate], SR252 [polyethylene glycol (600) dimethacrylate], all Sartomer products; EBECRYL 11 [poly ethylene glycol diacrylate from Allnex; Genomer 1251 [polyethylene glycol 400 diacrylate] from Rahn.
Polyethylene glycol (600) diacrylate, available as SR610 from Sartomer, is particularly preferred.

Particularly preferred difunctional acrylate or methacrylate monomers are e.g. butane diol diacrylate, alkoxylated hexanediol diacrylate, alkoxylated neopentyl glycol diacrylate and alkoxylated hexanediol dimethacrylate.

### Oligomer

The curable composition may further comprise an oligomer. The amount of oligomer is preferably between 5 and 50 wt%, more preferably between 10 and 40 wt%, most preferably between 15 and 30 wt %.

Preferred oligomers are urethane acrylate oligomers. These oligomers are prepared by reacting polyisocyanates with hydroxyl alkyl acrylates, usually in the presence of a polyol compound. Their functionality (i.e. number of acrylate groups) varies from 1 to 6. A lower functionality results in lower reactivity, better flexibility and a lower viscosity. Therefore, mono- or difunctional urethane acrylate oligomers are preferably used in the present invention. The polyol compound forms the backbone of the urethane acrylate. Typically the polyol compounds are polyether or polyester compounds with a functionality (hydroxyl groups) ranging from two to four. Polyether urethane acrylates are generally more flexible, provide lower cost, and have a slightly lower viscosity and are therefore preferred.

Aliphatic and aromatic urethane acrylate oligomers may be used. However, aliphatic urethane acrylate oligomers are preferred for their better light stability.
Examples of aliphatic urethane acrylate oligomers that may be used are CN2920, CN3211, CN9001, CN9009, CN9010 (all available from SARTOMER), Genomer 1122 (available from Rahn AG) and Ebecryl 1039 (available from Allnex).

Examples of aromatic urethane acrylate oligomers are CN976 and CN9761 (from SARTOMER).

Other preferred oligomers are aromatic epoxy acrylates. An example of such an aromatic epoxy acrylate is CN UVE 151 (from SARTOMER).

### Initiators

The curable composition may comprise an initiator which, upon exposure to radiation or heat, initiates the curing, i.e. polymerization, of the coated formulation.

However, it is also possible to carry out the curing by electron beam radiation where the presence of an initiator is not mandatory.

Preferably a photo-initiator is used which upon absorption of actinic radiation, preferably UV-radiation, forms high-energy species (for example radicals) inducing polymerization and crosslinking of the monomers and oligomers of the coated formulation.

A combination of two or more photo-initiators may be used. A photo-initiator system, comprising a photo-initiator and a co-initiator, may also be used. A suitable photo-initiator system comprises a photo-initiator, which upon absorption of actinic radiation forms free radicals by hydrogen abstraction or electron extraction from a second compound, the co-initiator. The co-initiator becomes the actual initiating free radical.

Irradiation with actinic radiation may be realized in two steps, each step using actinic radiation having a different wavelength and/or intensity. In such cases it is preferred to use 2 types of photo-initiators, chosen in function of the different actinic radiation used.

Suitable photo-initiators are disclosed in EP-A 1637926 paragraph [0077] to [0079].

A preferred total amount of initiator is 1 to 15 wt%, more preferably 2.5 to 12 wt%, of the total curable composition.

### Inhibitors

Suitable polymerization inhibitors include phenol type antioxidants, hindered amine light stabilizers, phosphor type antioxidants, hydroquinone monomethyl ether commonly used in (meth)acrylate monomers, and hydroquinone, methylhydroquinone, t-butylcatechol, pyrogallol may also be used. Of these, a phenol compound having a double bond in molecules derived from acrylic acid is particularly preferred due to its having a polymerization-restraining effect even when heated in a closed, oxygen-free environment. Suitable inhibitors are, for example, Sumilizer^{®} GA-80, Sumilizer^{®} GM and Sumilizer^{®} GS produced by Sumitomo Chemical Co., Ltd.

Since excessive addition of these polymerization inhibitors will lower the sensitivity to curing of the curable jettable liquid, it is preferred that the amount capable of preventing polymerization be determined prior to blending. The amount of a polymerization inhibitor is generally between 200 and 20 000 ppm of the total curable composition.

### Oxygen inhibition

Suitable combinations of compounds which decrease oxygen polymerization inhibition with radical polymerization inhibitors are: 2-benzyl-2-dimethylamino-1-(4-morpholinophenyl)-butane-1 and 1-hydroxy-cyclohexyl-phenyl-ketone; 1-hydroxy-cyclohexyl-phenyl-ketone and benzophenone; 2-methyl-1[4-(methylthio)phenyl]-2-morpholino-propane-1-on and diethylthioxanthone or isopropylthioxanthone; and benzophenone and acrylate derivatives having a tertiary amino group, and addition of tertiary amines. An amine compound is commonly employed to decrease an oxygen polymerization inhibition or to increase sensitivity. However, when an amine compound is used in combination with a high acid value compound, the storage stability at high temperature tends to be decreased.
Synergist additives may be used to improve the curing quality and to diminish the influence of the oxygen inhibition. Such additives include, but are not limited to ACTILANE^{®} 800 and ACTILANE^{®} 725 available from AKZO NOBEL, Ebecryl^{®} P115 and Ebecryl^{®} 350 available from Allnex and CD 1012, Craynor CN 386 (amine modified acrylate) and Craynor CN 501 (amine modified ethoxylated trimethylolpropane triacrylate) available from CRAY VALLEY.

The content of the synergist additive is in the range of 0 to 20 wt.%, preferably in the range of 5 to 15 wt%, based on the total weight of the curable composition.

### Elastomeric binder

The elastomeric binder may be a single binder or a mixture of various binders. The elastomeric binder is an elastomeric copolymer of a conjugated diene-type monomer and a polyene monomer having at least two non-conjugated double bonds, or an elastomeric copolymer of a conjugated diene-type monomer, a polyene monomer having at least two non-conjugated double bonds and a vinyl monomer copolymerizable with these monomers.
Preferred elastomeric binders are disclosed in EP-A 1637926 paragraph [0092] and [0093].

### Surfactants

The surfactant(s) may be anionic, cationic, non-ionic, or zwitter-ionic and are usually added in a total amount below 20 wt%, more preferably in a total amount below 10 wt%, each based on the total curable composition.

Fluorinated or silicone compounds are preferably used as a surfactant, however, a potential drawback is bleed-out after image formation because the surfactant does not cross-link. It is therefore preferred to use a copolymerizable monomer having surface-active effects, for example, silicone-modified acrylates, silicone modified methacrylates, fluorinated acrylates, and fluorinated methacrylates.

### UV absorbers

The curable composition preferably comprises a UV absorber to impart UV stability to the weather resistant layer. A UV light absorbing compound absorbs at least part of the UV light that reaches the weather resistant layer.

The UV light absorbing compound may be an organic or an inorganic UV absorbing compound.

The UV light absorbing compounds and UV light stabilizers that may be added to the polyester support (see below) may also be used in the weather resistant layer.

Preferred UV light absorbing compounds are inorganic UV absorbing particles such as Ti0₂ particles, ZnO particles and mixtures thereof. The particle size of these inorganic UV absorbing compounds is preferably between 0.01 and 5.00 *µ*m, more preferably between 0.10 and 2.50 *µ*m, most preferably between 0.20 and 1.00 *µ*m

The amount of the inorganic UV absorbing particles in the weather resistant layer is preferably between 2.5 and 20 g/m² more preferably between 5 and 15 g/m²

### Solvents

The curable composition preferably does not contain an evaporable component, but sometimes, it can be advantageous to incorporate an extremely small amount of a solvent to improve adhesion to the polymeric support after curing.

### Humectants

When a solvent is used in the curable composition, a humectant may be added to prevent blocking of the coating head, due to its ability to slow down the evaporation rate of curable liquid.
Suitable humectants are disclosed in EP-A 1637926 paragraph [0105]. A humectant is preferably added to the curable composition preferably in an amount of 0.1 to 20 wt %.

### Coating of the curable composition

The weather resistant layer of the backsheet is prepared by coating the curable composition on the polymeric support.

Any coating techniques may be used such as air knife coating, slide coating, cascade coating, curtain coating, slot coating, roll coating, gravure coating, etc. The curable liquid may also be applied on the support by jetting.

Preferably, a metered dosing technique to carefully control the coating thickness of both ionomer layers is used. The coating thickness is preferably between 5 and 50 *µ*m, more preferably between 10 and 40 *µ*m.

### Curing

Curing can be "partial" or "full". The terms "partial curing" and "full curing" refer to the degree of curing, i.e. the percentage of converted functional groups, and may be determined by, for example, RT-FTIR (Real-Time Fourier Transform Infa-Red Spectroscopy) which is a method well known to the one skilled in the art of curable formulations. Partial curing is defined as a degree of curing wherein at least 5 %, preferably 10 %, of the functional groups in the coated formulation is converted. Full curing is defined as a degree of curing wherein the increase in the percentage of converted functional groups with increased exposure to radiation (time and/or dose) is negligible. Full curing corresponds with a conversion percentage that is within 10 %, preferably 5 %, from the maximum conversion percentage. The maximum conversion percentage is typically determined by the horizontal asymptote in a graph representing the percentage conversion versus curing energy or curing time. When in the present application the term "no curing" is used, this means that less than 5 %, preferably less than 2.5 %, most preferably less than 1 %, of the functional groups in the coated formulation are converted.

Curing may be performed by heating (thermal curing), by exposing to actinic radiation (e.g. UV curing) or by electron beam curing.

Curing of the coated curable composition is preferably carried out before the polymeric support comprising the coated weather resistant layer is coiled or slitted.

Any UV light source, as long as part of the emitted light can be absorbed by the photo-initiator or photo-initiator system of the curable composition, may be employed as a radiation source, such as, a high or low pressure mercury lamp, a cold cathode tube, a black light, an ultraviolet LED, an ultraviolet laser, and a flash light. For curing the coating from the curable composition, the imaging apparatus preferably has a plurality of UV light emitting diodes. The advantage of using UV LEDs is that it allows a more compact design of the imaging apparatus.
UV radiation is generally classified as UV-A, UV-B, and UV-C as follows:
- UV-A: 400 nm to 320 nm
- UV-B: 320 nm to 290 nm
- UV-C: 290 nm to 100 nm

The most important parameters when selecting a curing source are the spectrum and the intensity of the UV-light. Both parameters affect the speed of the curing. Short wavelength UV radiation, such as UV-C radiation, has poor penetration capabilities and enables to cure primarily on the outside of the coated layer. A typical UV-C light source is low pressure mercury vapour electrical discharge bulb. Such a source has a small spectral distribution of energy, with only a strong peak in the short wavelength region of the UV spectrum.

Long wavelength UV radiation, such as UV-A radiation, has better penetration properties. A typical UV-A source is a medium or high pressure mercury vapour electrical discharge bulb. Recently UV-LEDs have become commercially available which also emit in the UV-A spectrum and that have the potential to replace gas discharge bulb UV sources. By doping the mercury gas in the discharge bulb with iron or gallium, an emission can be obtained that covers both the UV-A and UV-C spectrum. The intensity of a curing source has a direct effect on curing speed. A high intensity results in higher curing speeds.
The curing speed should be sufficiently high to avoid oxygen inhibition of free radicals that propagate during curing. Such inhibition not only decreases curing speed, but also negatively affects the conversion ratio of monomer into polymer. To minimize such oxygen inhibition, the imaging apparatus preferably includes one or more oxygen depletion units. The oxygen depletion units place a blanket of nitrogen or other relatively inert gas (e.g.CO₂), with adjustable position and adjustable inert gas concentration, in order to reduce the oxygen concentration in the curing environment. Residual oxygen levels are usually maintained as low as 200 ppm, but are generally in the range of 200 ppm to 1200 ppm.
Another way to prevent oxygen inhibition is the performance of a low intensity pre-exposure before the actual curing.

Overall curing is preferably carried out with UV-A light. A final post curing however is often realized with UV-C light or with broad spectrum UV light. Final curing with UV-C light has the property that the surface of the coated layer is fully hardened.

The UV absorbing compounds which are preferably present in the curable composition may render UV curing less efficient. Therefore, in a preferred embodiment of the invention, electron beam curing is used to cure the coated curable composition. When electron beam curing is used, the amount of UV absorbing compounds has no influence on the curing efficiency. Moreover when electron beam curing is used, the curable composition does not need a photo-initiator.

Electron beam (EB) curing is well known in the art. In EB curing, a curtain of accelerated electrons is emitted towards the web in an evacuated chamber. The highly energetic electrons pass through a titanium window foil towards the web in a nitrogen inerted process zone. When the energetic electrons hit the wet coating, the energy is absorbed by the layer and the curing process takes place, instantaneously without the need for a photoinitiator. When electrons hit metal, X-ray radiation is emitted. Therefore, the electron beam equipment is covered in a stainless steel and lead shielding to absorb the X-ray energy. None of this radiation is emitted outside the process zone of the EB equipment.

### Primer to the encapsulant

The surface of the polymeric support may be provided with a primer or adhesive layer to improve the adhesion of the backsheet to the encapsulant or sealing material. The backsheet then comprises the weather resistant layer on one side of the support and a primer (11) on the other side of the support to enhance the adhesion of the backsheet towards an encapsulant layer (2').

The primer may comprise a binder. The binder may be selected from polyolefins, polyesters, acrylic resins and polyurethanes. The binder may also be a composite resin of acrylic polymer and silicone. Examples of such binders are Chemipearl S-120 and S-75N, both polyolefins from Mitsui Cemicals, Jurymer ET-410 and SEK-301, both acrylic resins from Nihon Junyaku, Ceranate WSA1060 and 1070, both composite resins of an acrylic polymer and silicone from DIC, and H7620, H7630, and H7650, all composite resins of an acrylic polymer and silicone from Asahi Kasei Chemicals.

The amount of binder is typically from 0.05 to 5.00 g/m², more preferably from 0.08 to 3.00 g/m².

The primer may also comprise crosslinking agents, selected from epoxy compounds, isocyanate compounds, melamine compounds, carbodiimide compounds and oxazoline compounds. Examples of oxazoline compounds are disclosed WO2011/118844 paragraph [0058]-[0060]. Commercially available oxazoline compounds are for example EPOCROS K2010E, K2020E, WS-500, WS-700 all available from Nippon Shokubai.

EP-A 2479026 discloses a preferred polyurethane based primer wherein the polyurethane has a polycarbonate or a polyether skeleton and wherein the primer further comprises a crosslinking agent. Preferred crosslinking agents are oxazoline and carbodiimide compounds. The polyurethane is preferably used in the form of a dispersion or a solution having water as medium. For that reason, the crosslinking agents are also preferably water-soluble or water-dispersible.

It has been observed that a crosslinkable fluorpolymer, such as those described below for the weather resistant layer, may also be used as binder for the primer towards the encapsulant.

The primer may contain inorganic fine particles. These may be selected from silica, calcium carbonate, magnesium oxide, magnesium carbonate, and tin oxide. Tin oxide and silica are preferred.
The particle size of the inorganic particles is preferably from 10 to 700 nm, more preferably from 20 to 300 nm.
The amount of these inorganic particles is preferably between 5 and 400 wt %, more preferably between 10 and 300 wt %, relative to the binder.

The primer may also contain matting agents, such as polystyrene, poly(methyl methacrylate) or polyamide matting agents.

The primer may also contain a surfactant, such as an anionic or nonionic surfactant.

The primer is preferably applied on the polymeric support by coating a coating liquid on the support. Any known coating method, such as gravure coating, roll coating, bar coating, knife coating or curtain coating may be used. The primer may also be jetted on the support. The coating solvent may be water or an organic solvent, such as for example MEK, ethyl acetate, or butyl acetate.

The thickness of the primer is preferably between 0.05 and 8 *µ*m, more preferably between 0.1 and 5 *µ*m. The primer may consist of one layer or of two or more layers.

The surface of the support on which the primer is applied may be surface treated, as described above, to improve the adhesion of the primer (and the encapsulant) to the polymeric support.

The coating solution of the primer may be applied on the polymeric support before or after the support has been biaxially stretched or, more preferably, in between the longitudinal and lateral stretching.

### Primer to the weather resistant layer

A primer (12) may be provided between the polymeric support (10) and the weather resistant layer (13) to improve the adhesion between both.

The thickness of such a primer is preferably less than 2 *µ*m, more preferably between 0.05 and 2.00 *µ*m, even more preferably between 0.1 and 1.50 *µ*m.

The primer may contain a binder, for example polyesters, polyurethanes, acrylic resins, or polyolefins. Apart from the binder, the primer may also contain compounds selected from epoxy compounds, isocyanate compounds, melamine compounds, carbodiimide compounds and oxazoline compounds, a surfactant selected from anionic, cationic, and nonionic surfactants, or a filler, such as silica.

The coating method for the primer may be any conventional coating method, for example a gravure coater or a bar coater may be used.

The coating solvent of the coating solution may be water or an organic solvent such as toluene or MEK. One or more solvents may be used singly or in combination.

The coating solution may be applied on the polymeric support before or after the support has been biaxially stretched or, more preferably, in between the lateral and longitudinal stretching.

### Support

The support, also referred to as substrate, used in the backsheet of the present invention is preferably a polymeric support. The support may be provided with additional layers to improve the adhesion towards the primer and/or the weather resistant layer.

Examples of a polymeric support include supports made of polyesters, polyolefins, such as polypropylene and polyethylene, or polyamides, such as polyamide 12 (Nylon 12). Examples of polyesters that can be used for the support are polyethylene terephthalate (PET), polybutylene terephthalate (PBT), 2,6-naphthalene terephthalate (PEN), a copolymer of 1,4-cyclohexanedimethanol, 1,2-ethanediol and 1,4-benzenedicarboxylic acid (PETG) and a copolyester containing isosorbide. A particularly preferred support is a PET support.

### Production of a polyester support

A typical polyester resin production process comprises two phases: an esterification and/or transesterification step of a dicarboxylic acid, or its ester derivative, and a diol compound, followed by a polycondensation step.

Optionally, the resulting polyester after the polycondensation step may be subjected to a so called solid state polymerization to further increase the Molecular Weight (MW) of the polyester, for example to decrease the amount of terminal carboxyl groups.

The resulting polyester resin is then fed to a melt extruder to form a polyester film which is then biaxially stretched to form a biaxially oriented polyester film (i.e. the polyester support) having a specific thickness.
A catalyst is typically used in the polyester production process. Such a catalyst may be present in the esterification step, in the polycondensation step, or in both.

Several other compounds may be added during the polyester production process, to optimize the polymerization reaction and/or the physical properties of the resulting polyester resin or film. Such compounds may be present in the esterification step, in the polycondensation step, in both the esterification and the polycondensation step, or may be added together with the polyester resin to the melt extruder before film formation.

### Dicarboxylic acid

The dicarboxylic acids may be selected from aliphatic, alicyclic and aromatic dicarboxylic acids.
Examples of an aliphatic dicarboxylic acid are malonic acid, succinic acid, glutaric acid, adipic acid, suberic acid, sebacic acid, dodecanedioic acid, dimer acid, eicosane dioic acid, pimelic acid, azelaic acid, methylmalonic acid and ethylmalonic acid. Examples of an alicyclic dicarboxylic acid are adamantane dicarboxylic acid, norbornene dicarboxylic acid, cyclohexanedicarboxylic acid and decalin dicarboxylic acid. Examples of an aromatic dicarboxylic acid are terephthalic acid, isophthalic acid, phthalic acid, 1,4-naphthalene dicarboxylic acid, 1,5-naphthalene dicarboxylic acid, 2,6-naphthalene dicarboxylic acid, 1,8-naphthalene dicarboxylic, 4,4'-diphenyl dicarboxylic acid, 4,4'-diphenylether dicarboxylic acid, and 5-sodium-sulfoisophthalic acid.

Preferably, at least one aromatic dicarboxylic acid is used. More preferably, at least 80 wt % of the dicarboxylic acids used is an aromatic dicarboxylic acid. Most preferably, the dicarboxylic acids used are selected from terephthalic acid and isopthalic acid.

### Diol compound

The diol compounds may be selected from aliphatic diol compounds, alicyclic diol compounds and aromatic diol compounds.
Examples of aliphatic diol compounds are ethylene glycol, 1,2-propanediol, 1,3-propanediol, 1,4-butanediol, 1,2-butanediol, and 1,3-butanediol.
Examples of alicylic diol compounds are cyclohexane dimethanol, spiroglycol, isosorbide, and 2,2,4,4-tetramethyl-1,3-cyclobutanediol (CBDO).
Examples of aromatic diol compounds are bisphenol A, 1,3-benzene-dimethanol, and 1,4-benzenedimethanol.

Preferably, at least one aliphatic diol compound is used. Most preferably, ethylene glycol is used as diol compound.

### Compounds having three or more carboxyl groups or hydroxyl groups

When using a small amount of compounds having three or more carboxyl groups or hydroxyl groups, branching of the polyester molecular chains may be induced, therefore promoting the entanglement of the polyester chains. As a result, when the polyester molecules are hydrolyzed and the molecular weight of the polyester is thereby lowered, embrittlement of the polyester film can be avoided. Such an entanglement may also inhibit thermal shrinkage of the polyester film. Such compounds and the preferred amounts used thereof are disclosed for example in US2011/0306747, paragraphs [0121] to [0127].

### Esterification

The aromatic dicarboxylic acid and the aliphatic diol may be introduced into the production process by preparing a slurry containing these compounds, and supplying the slurry to the esterification phase. The esterification may be carried out using a multistage unit of at least two reactors connected in series, in which ethylene glycol is kept under reflux and water and alcohol formed by the reaction are removed out of the system.

The amount of the aliphatic diol, for example ethylene glycol, is preferably between 1.015 and 1.50 mol per mol of the aromatic dicarboxylic acid, for example terephthalic acid, or its ester derivative, more preferably between 1.10 and 1.30 mol, most preferably between 1.15 and 1.25 mol.

### Polycondensation

The esterified product produced in the esterification step is then polycondensed. The polycondensation may be carried out in one stage or in multiple stages. The polycondensation is typically carried out under reduced pressure.

### Catalyst

In the polyester production process, any known conventional catalyst may be used, such as alkali metal compounds, alkaline earth metal compounds, zinc compounds, lead compounds, manganese compounds, cobalt compounds, aluminium compounds, antimony compounds, titanium compounds, germanium compounds, or phosphorus compounds. Preferably an antimony compound, a germanium compound or a titanium compound is used in the polyester production.

Most preferably, a titanium catalyst (Ti catalyst) is used. The Ti catalyst includes oxides, hydroxides, alkoxides, carboxylates, carbonates, oxalates, organic chelate Ti complexes, and halides. Two or more different types of Ti compounds may be used. Preferred Ti catalysts are organic chelate Ti complexes with an organic acid as a ligand. The organic acid may be selected from citric acid, lactic acid, trimellitic acid, and malic acid. Preferably a chelate Ti complex with citric acid as ligand is used. Such a citrate chelate Ti catalyst is commercially available as Tyzor AC422 from Dorf Ketal or Ti184 from Catalytic Technologies.

The catalyst may be added in the esterification phase, in the polycondensation phase or in both phases. The amount of the catalyst is preferably from 1 to 50 ppm, more preferably from 2 to 30 ppm, most preferably from 3 to 15 ppm, in terms of the Ti element.

### Phosphorus compound

Preferably, a pentavalent phosphorus compound not having an aromatic ring as a substituent is used in combination with a Ti catalyst.

The pentavalent phosphorus compound may be selected from trimethyl phosphate, triethyl phosphate, tri-n-butyl phosphate, trioctyl phosphate, tris(triethylene glycol) phosphate, methyl acid phosphate, ethyl acid phosphate, monobutyl phosphate, dibutyl phosphate, dioctyl phosphate, and triethylene glycol acid phosphate. Most preferably trimethyl phosphate and triethyl phosphate are used. In combination with the citrate chelate Ti catalyst mentioned above, using trimethyl phosphate or triethyl phosphate results in a polyester resin having a balanced polymerization activity, color tone and thermal stability.

The pentavalent phosphorus compound is preferably added in the esterification phase, but may also be added to the polycondensation phase or to both phases. The amount of pentavalent phosphorus compound is preferably from 1 to 100 ppm, more preferably from 5 to 50 ppm, most preferably from 7.5 to 25 ppm, in terms of the P element.

### Magnesium compound

Adding a magnesium compound (Mg compound) imparts static electricity properties to the resin film. The magnesium compound may be selected from magnesium oxide, magnesium hydroxide, magnesium alkoxide, magnesium acetate, and magnesium carbonate. Among these magnesium compounds, magnesium acetate is preferred.

The Mg compound may be added in the esterification phase, in the polycondensation phase or in both phases. The Mg compound may also be added in the extruder, i.e. in the melt. The amount of the magnesium compound is preferably from 1 to 100 ppm, more preferably from 2 to 50 ppm, most preferably from 3 to 30 ppm, in terms of the Mg element.

### Polyester film formation

### Extrusion

After the polycondensation step, the polycondensation product is either directly fed to the melt extruder, or the polycondensate product is first pelletized and then melted in the extruder.

The melt temperature in the extruder is preferably from 250 to 320°C, more preferably from 260 to 310°C, most preferably from 270 to 300°C. The extruder may be a single-screw extruder or a multi-screw extruder. The extruder may be purged with nitrogen to prevent the formation of terminal carboxyl groups through thermal oxidative (or thermo-oxidative) decomposition.

The melt is preferably extruded out through an extrusion die via a gear pump and a filter unit.
The extruded melt is then cooled on one or more chill rolls to form a film thereon. The temperature of the chill rolls is preferably from 5 to 80°C, more preferably from 15 to 70°C, most preferably from 20 to 60°C. When two chill rolls are used, the temperature of both may be different, for example between 5 and 25°C for the first chill roll and between 30 and 60°C for the second chill roll.

To enhance the adhesion between the resin melt and the chill roll and to increase the cooling efficiency, static electricity is preferably applied to the chill roll before the melt is brought into contact therewith.

### Stretching

The extruded film is then stretched, preferably biaxially stretched, to obtain the polyester film.

The draw ratio in both the longitudinal and the lateral direction is preferably between 2 and 5. In biaxial stretching, the order of longitudinal stretching (the Machine Direction (MD) or the running direction of the film) and lateral stretching (Cross Direction (CD) or the width direction) is not specifically defined. Preferably, the longitudinal stretching is carried out first.
It is preferred that the lateral draw ratio is larger than the longitudinal draw ratio. Preferably the lateral draw ratio/ longitudinal draw ratio is from 1.05 to 1.25, more preferably from 1.10 to 1.20.
The stretching temperature is preferably from 80 to 160°C, more preferably from 85 to 155°C. It is preferred that the stretching temperature in the latter stretching, preferably the lateral stretching, is higher than the temperature in the former stretching, preferably the longitudinal stretching.

Besides this stepwise biaxially stretching method, wherein stretching in a longitudinal direction and stretching in a width direction are performed separately, a simultaneous biaxially stretching method, wherein stretching in a longitudinal direction and stretching in a lateral direction are performed at the same time, may also be used.

### Thermofixation

In order to complete crystal orientation and to impart flatness and dimensional stability to the biaxially stretched film, the film is preferably subjected to a heat treatment for 1 to 30 sec while the sides of the biaxially stretched film are fixed, preferably at a temperature equal or higher than the glass transition temperature (Tg) of the resin but lower than the melting temperature (Tm) thereof. Such a heat treatment is then followed by a uniform and gradual cooling to room temperature.

Such a treatment is often referred to as thermofixation.
When the thermofixation temperature is too low, the heat shrinkage of the resulting film increases. On the other hand, when the heat treatment temperature is too high, the hydrolytic stability of the resulting film decreases. Preferred thermofixation temperatures are between 160 and 250°C, more preferably between 175 and 235°C, most preferably between 200 and 225°C.

### Relaxation

In addition to and after the thermofixation, a so called relaxation treatment may be carried out. Such a relaxation treatment is preferably carried out at a temperature from 80 to 160°C, more preferably from 100 to 140°C. The degree of relaxation is from 1 to 30%, more preferably from 2 to 25 %, most preferably from 3 to 20 %.

The relaxation may be attained in the lateral or longitudinal direction of the film, or in both directions.

### Thickness of the film

The thickness of the biaxially stretched polyester film is preferably between 75 *µ*m and 500 *µ*m, more preferably between 100 *µ*m and 350 *µ*m, most preferably between 125 *µ*m and 250 *µ*m.

### Carboxyl groups in the polyester

Carboxyl groups present in the polyester may work as an acid catalyst in the hydrolysis of polyester molecules. Such hydrolysis, for example when the polyester is kept for a certain period of time in high moisture conditions, results in a decrease of the molecular weight and therefore in a decrease of the mechanical strength of the polyester film. To obtain a sufficient hydrolytic stability of the polyester film, the carboxyl group content is preferably as low as possible.

On the other hand, carboxyl groups at the surface of the polyester film may enhance the adhesion between the polyester film and layers provided thereon. For that reason, the carboxyl group content is preferably not zero.

The carboxyl group content of the polyester film is preferably between 0 and 40 meq/kg, more preferably between 5 and 20 meq/kg.

To ensure low concentrations of carboxyl groups in the polyester film, high temperatures during the complete preparation process of the film, for example during the polycondensation process, are kept as low as possible.

To further reduce the number of carboxyl groups of the polyester, compounds that react with a carboxyl group of the polyester may be added to the polyester. Examples of such compounds include carbodiimide compounds, epoxy compounds, and oxazoline compounds.

### Carbodiimide compounds

The carbodiimide compounds may be classified into monofunctional and polyfunctional carbodiimides. Examples of monofunctional carbodiimides include N,N'-dicyclohexylcarbodiimide, 1,3-diisopropylcarbodiimide, N,N'-diisopropylphenylcarbodiimide, N,N'-dimethyl-carbodiimide, N,N'-diisobutylcarbodiimide, N,N'-dioctylcarbodiimide, t-butylisopropylcarbodiimide, N,N'-diphenylcarbodiimide, N,N'-di-t-butyl-carbodiimide, 1-(3-dimethylaminopropyl)-3-ethyl carbodiimide, and dinaphthyl carbodiimide.

Examples of commercially available carbodiimide compounds include Stabaxol I from Rheinchemie and Stabilizer 7000 from Rashig, both based on N,N'-diisopropylphenylcarbodiimide.

Polyfunctional carbodiimides are typically polycarbodiimide compounds, i.e. a polymer obtained by polymerizing a carbodiimide compound. An specific example of such a polycarbodiimide is poly(1,3,5-triisopropylphenylene-2,4-dicarbodiimide).

Examples of commercially available polymeric carbodiimides include Stabilizer 9000 from Raschig and Stabaxol P from Rheinchemie. Other polymeric carbodiimides availabe from Rheinchemie are Stabaxol P100 and Stabaxol P200.

As carbodiimide compounds may generate an isocyanate-type gas through thermal decomposition, carbodiimide compounds having a high heat resistance are preferably used. It has been observed that an increase in molecular weight of polymeric carbodiimides, results in an improvement of the thermal decomposition.

### Epoxy compounds

Preferred examples of the epoxy compounds include glycidyl ester compounds and glycidyl ether compounds. Other preferred examples are those disclosed in WO2012120260 (for example Cardura E10P).
Other preferred epoxy compounds are epoxidized fatty acid esters or epoxidized fatty acid glycerides such as disclosed in US2010/0120946 paragraphs [0020] to [0067].

Still other preferred epoxy compounds are the so called chain extenders disclosed in for example US2010/0120947. Chain extenders are molecules with at least two reactive groups, preferably an epoxy group, which can react with the polyester during extrusion and join polyester chains to one another. Typically, their reactive groups are already depleted substantially (to an extent of 75 % or more) during the extrusion and are no longer available for a chain repair during the use of the polyester film after the production thereof. Preferred chain extenders are difunctional epoxides, even more preferred chain extenders are polyfunctional epoxides. The epoxy function is arranged terminally at the end of the molecule chain or of a side chain. Polyfunctional epoxides are preferred since lower amounts are required, higher molecular weight end products are formed, and lower level of gaseous cleavage products are formed. Commercially available chain extenders include polymers sold by BASF under the Joncryl ADR brand name.

### Oxazoline compounds

The oxazoline compounds are preferably bisoxazoline compounds such as 2,2'-bis(2-oxazoline), 2,2'-bis(4-methyl-2-oxazoline), 2,2'-bis(4,4'-dimethyl-2-oxazoline), 2,2'-bis(4-methyl-2-oxazoline), 2,2'-bis(4-ethyl-2-oxazoline), 2,2'-bis(4,4'-diethyl-2-oxazoline),2,2'-bis(4-propyl-2-oxazoline), 2,2'-bis(4-butyl-2-oxazoline), 2,2'-bis(4-hexyl-2-oxazoline), 2,2'-bis(4-phenyl-2-oxazoline), 2,2'-bis(4-cylcohexyl-2-oxazoline), 2,2'-bis(4-benzyl-2-oxazoline), 2,2'-p-phenylenebis(2-oxazoline), 2,2'-m-phenylenebis (2-oazoline), 2,2'-o-phenylenebis(2-oxazoline), 2,2'-p-phenylenebis(4-methyl-2-oxazoline), 2,2'-p-phenylenebis(4,4-dimethyl-2-oxazoline), 2,2'-m-phenylenebis(4,4-dimethyl-2-oxazoline), 2,2'-m-phenylenebis(4-methyl-2-oxazoline), 2,2'-m-phenylenebis(4,4-dimethyl-2-oxazoline), 2,2'-ethylenebis(2-oxazoline), 2,2'-tetramethylenebis(2-oxazoline), 2,2'-hexamethylenebis(2-oxazoline), 2,2'octamethylenebis(2-oxazoline), 2,2'-decamethylenebis(2-oxazoline), 2,2'-ethylenebis(4-methyl-2-oxazoline), 2,2'-ethylenebis(4,4-dimethyl-2-oxazoline), 2,2'-9,9'-diphenoxyethanebis(2-oxazoline), 2,2'-cyclohexylenebis(2-oxazoline) and 2,2'-diphenylenebis(2-oxazoline). Among these, 2,2'-bis(2-oxazoline) is most preferably used from the viewpoint of reactivity with the polyester.

A particularly preferred oxazoline compound is 2-Phenyl-4,5-dihydrooxazole and 4,5-Dihydro-2-phenyl-6H-1,3-oxazine.

The bisoxazoline compounds may be used individually, or two or more different compounds may be used together.

The amount of the carbodiimide compounds, the epoxy compounds, or the oxazoline compounds in the polyester film is typically from 0.1 to 5 wt %, preferably from 0.3 to 4 wt %, more preferably from 0.5 to 3 wt %, relative to the total weight of the polyester resin.

### UV light absorber/UV light stabilizer

To prevent degradation caused by UV light, UV light absorbers and/or UV light stabilizers may be added to the polyester film. UV light absorbers absorb UV light and convert it into heat energy, while UV light stabilizers scavenge radicals generated by photodecomposition of the polyester resin and prevent further decomposition of the resin. A degradation of the polyester resin may result in a decrease of the partial discharge voltage, in a decrease of the strength of the polyester film, and in a color tone change (for example yellowing) of the polyester film.

The UV light absorbing compound may be an organic or an inorganic UV absorbing compound.

Examples of organic UV light absorbers include salicyl acid compounds such as p-t-butylphenylsalicylate or p-octylphenyl salicylate, benzophenone compounds such as 2,4-dihydroxy benzophenone, 2-hydroxy-4-methoxy benzophenone, 2-hydroxy-4-methoxy-5-sulfo benzophenone, 2,2'4,4'-tetrahydroxy benzophenone, and bis(2-methoxy-4-hydroxy-5-benzoylphenyl)methane, benzotriazole compounds such as 2-(2'-hydroxy-5'-methylphenyl)benzotriazole and 2,2'-methylene bis[4-(1,1,3,3-tetramethylbutyl)-6-(2H-benzotriazole-2-yl)phenol], cyanoacrylate compounds such as ethyl-2-cyano-3,3'-diphenyl acrylate, triazine compounds such as 2-(4,6-diphenyl-1,3,5-triadizine-2-yl)-5-[(hexyl)oxy]-phenol (Tinuvin 1577) and 2-(2-Hydroxy-4-(2-ethylhexyl)oxyphenyl)-4,6-di(4-phenylphenyl)-1,3,5-triazine (Tinuvin 1600) and, 2-[4-[4,6-bis([1,1'-biphenyl]-4-yl)-1,3,5-triazin-2-yl]-3-hydroxyphenoxy]-propanoic acid isooctyl ester (Tinuvin 479).

Examples of inorganic UV absorbers are Ti0₂ particles, ZnO particles and mixtures thereof.

Examples of UV light stabilizers are hindered amine compounds such as bis(2,2,6,6-tetramethyl-4-piperidyl)sebacate and the polycondensate of dimethylsuccinate and 1-(2-hydroxyethyl)-4-hydroxy-2,2,6,6-tetramethyl piperidine.

The content of the UV light absorber or UV light stabilizer in the polyester resin composition is preferably from 0.1 to 10 wt %, more preferably from 0.3 to 7 wt %, even more preferably from 0.7 to 4 wt %.

### Other additives

It is preferred to add inorganic particles to the polyester to optimize properties as slipperiness, abrasion resistance, scratch resistance of the surface of the polyester film. Examples of inorganic particles are for example particles of clay, mica, titanium oxide, calcium carbonate, kaolin, talc, silica, calcium phosphate, barium sulfate, alumina, and zirconia.
Preferred inorganic particles are silica and alumina. The amount of silica and/or alumina is preferably between 0.025 and 1.500 wt %, more preferably between 0.050 and 1.000 wt %.

Optical brighteners such as 2,5-thiophenediylbis(5-tert-butyl-1,3-benzoxazole) (Uvitex OB, Benetex OB Plus) may also be added to the polyester.

### Master batch technology

It is preferred that additives such as inorganic particles, UV light absorbing compounds, additives to improve the hydrolytic resistance are added to the polyester resin by means of a so called master batch. To prepare such a master batch, the additive is first dispersed in a carrier material. The carrier material is preferably polyester, but it may be another polymer which is compatible with polyester. The master batch is added to the polyester in the melt extruder, before film production, resulting in the components of the master batch being dissolved or finely dispersed in the polyester. Surface treatment

The polymeric support may be surface treated, typically to enhance the adhesion between the support and layers provided thereon.

Examples of such a surface treatment include a corona discharge treatment, a flame treatment, an UV treatment, a low pressure plasma treatment, and an atmospheric plasma treatment. A chemical treatment of the surface is also known in the art.

In a corona discharge treatment, typically high frequency and high voltage electricity is applied between a metal roll coated with a dielectric substance and insulated electrodes to induce ionization of the air between the electrodes, i.e. a corona discharge. A corona discharge treatment of the support is performed by passing the support through the corona discharge. Coronization may also been performed in modified atmospheric conditions.

For example, a gap distance between the electrodes and the dielectric roll may be from 1 to 3 mm, a frequency of 1 to 100 kHz, and an applied energy of 0.2 to 5 kV.A.min/m² may be used.

In a flame treatment, the outer flame portion of a flame is brought into contact with the support. Care has to be taken that the flame, uniformly hits the support surface. This may be achieved by using plural, circular-shaped burners. Examples of the combustion gas that may be used in a flame treatment include paraffin-based gases such as natural gas, methane gas, ethane gas, propane gas and butane gas, and olefin-based gases such as ethylene gas, propylene gas, and acetylene gas. These gases may be used singly, or as mixtures of two or more gases. Oxygen or air is preferably used as an oxidizing gas that is mixed with the combustion gas.
A flame treatment as disclosed in US2011/0284075, paragraph [0247] to [0258] is preferably used to optimize the surface energy of the polymeric support.

In an UV treatment, the surface of a support is irradiated with UV radiation to improve its adhesiveness and wettability. Typically, a low pressure mercury UV lamp is used as an UV radiation source. Preferably UV radiation at 254 nm, more preferably at 185 nm is used in such a UV treatment. The UV treatment is typically carried out for 1 to 500 seconds under atmospheric pressure.

In a low pressure plasma treatment, the surface of the support is treated with plasma, generated as a result of a discharge in a gas, the plasma gas, in a low pressure atmosphere. Examples of plasma gas that may be used include oxygen gas, nitrogen gas, water vapor gas, argon gas and helium gas. Preferably oxygen, or a mixed gas of oxygen gas and argon gas, are used. The pressure of the plasma gas is preferably in the range of 0.005 to 10 Torr, more preferably in the range of 0.008 to 3 Torr. The plasma output power is preferably from 100 to 2500 W, more preferably from 500 to 1500 W. The treatment time is preferably from 0.05 to 100 seconds, more preferably from 0.5 to 30 seconds. The plasma may be generated using a direct current glow discharge, a high frequency wave discharge, or a microwave discharge.

In an atmospheric pressure plasma treatment, a stable plasma discharge is generated at atmospheric pressure using high frequency waves. Argon gas or helium gas may be used as carrier gas. Oxygen gas may be mixed with the carrier gas. The atmospheric pressure plasma treatment is preferably carried out at atmospheric pressure or a pressure close to or below the atmospheric pressure, such as between 500 and 800 Torr. The power supply frequency of the discharge is preferably 1 to 100 kHz, more preferably 1 to 10 kHz. The discharge intensity is preferably from 50 to 500 W.min/m².

The surface treatment may be carried out on both surfaces of the polymeric support or to one surface of the support, the surface towards to weather resistant layer or the surface towards the encapsulant layer.

### Solar Cell Module

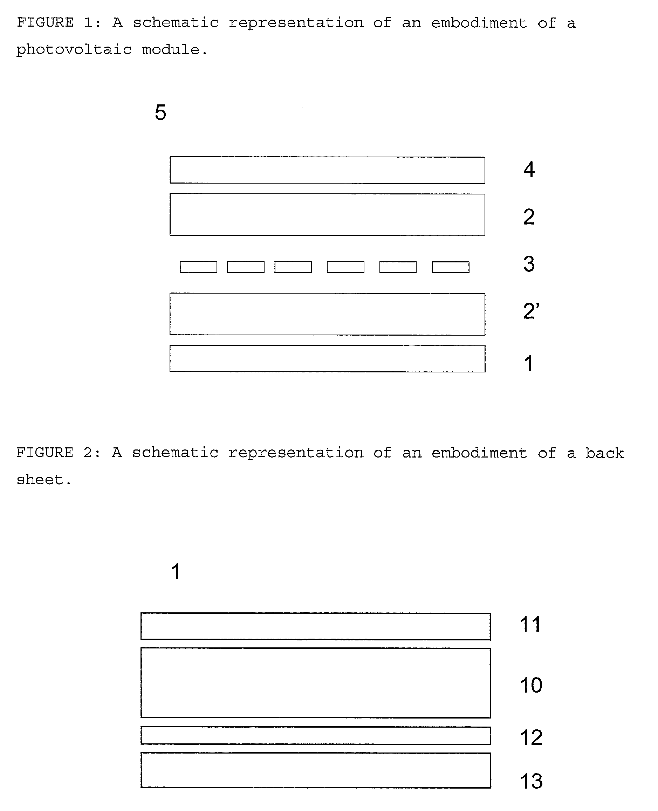

Figure 1 schematically represents an embodiment of a photovoltaic module according to the present invention.

The solar cell module (5) has a configuration in which a solar cell element (3), which converts the light energy of sunlight to electrical energy, is disposed between a transparent sheet (4) through which sunlight enters (also referred to as the front sheet) and the backsheet (1) according to the present invention. The solar cell element (3) is encapsulated by an encapsulant or sealing layer (2, 2').

Such a solar cell module is typically prepared by laminating all components, i.e. backsheet, front sheet, encapsulant sheets and the solar cell element, in one step.

A preferred embodiment of a backsheet (1) according to the present invention is schematically represented in Figure 2.
The backsheet (1) comprises a polymeric support (10), on one side of the support an optional primer (12) and a weather resistant layer (13), and a primer (11) on the other side of the support to enhance the adhesion towards an encapsulant layer (2').

To simplify the assembly of a solar cell module by the module manufacturer, it may be preferred to integrate the backsheet (1) and the encapsulant layer (2').

Such an integration may have a positive influence on the cost price of the solar cell module.

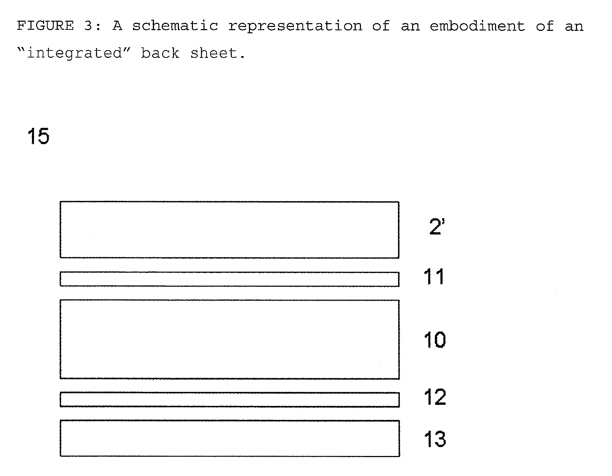

Figure 3 schematically represents an embodiment wherein the backsheet according to the present invention (1) is integrated with an encapsulant layer (2'). The encapsulant layer (2') may be applied to the backsheet (1) by a laminating an encapsulant layer on the backsheet or by extrusion coating an encapsulant layer on the backsheet.

### EXAMPLES

### Materials

All materials used in the examples were readily available from standard sources such as Aldrich Chemical Co. (Belgium) and Acros (Belgium) unless otherwise specified.
• TiPure R706 is a Ti0₂ pigment from DUPONT.
• Cupferron™ AL is aluminum N-nitrosophenylhydroxylamine from WAKO CHEMICALS LTD.
• DPGDA is a dipropyleneglycoldiacrylate (SR508) from SARTOMER.
• Efka 7701 is a dispersant for organic and inorganic pigments and carbon black from BASF.
• EOEOEA is an 2(2-ethoxyethoxy)ethyl acrylate (SR256) from SARTOMER.
• EOEOEMA is an 2(2-ethoxyethoxy)ethyl methacrylate from ABCR GmbH&Co.
• SR9003 is a propoxylated neopentyl glycol diacrylate from SARTOMER.
• CN9001 is an aliphatic urethane acrylate from SARTOMER
• CNUVE151 is an aromatic epoxy acrylate from SARTOMER.
• EBDA is a bisphenol A ethoxylate diacrylate from Scientific Polymer Products Inc.
• Genocure LTM is a photoinitiator from RAHN.
• Genocure MBF is a photoinitiator from RAHN.
• Byk UV 3510 is a wetting agent from BYK.
• SR340 is a 2-phenoxyethyl methacrylate from SARTOMER.
• SR339c is a 2-phenoxyethyl acrylate from SARTOMER.
• Ebecryl^{®} 4858 is an aliphatic urethane diacrylate from ALLNEX.
• SR285 is a tetrahydrofurfuryl acrylate from SARTOMER.
• SR203 is a tetrahydrofurfuryl methacrylate from SARTOMER.
• SR217 is an isobornyl acrylate from SARTOMER.
• SR423A is an isobornyl methacrylate from SARTOMER.
• FST510 is a diurethanedimethacrylate from AZ Electronic Materials.
• SR368 is a tris[2-hydroxy ethyl]isocyanurate triacrylate (THICTA) from SARTOMER.
• SR351 is a trimethylolpropane triacrylate (TMPTA) from SARTOMER.
• Miramer M600 is a dipentaerythritol hexaacrylate (DPHA) from RAHN.
• DISP-01 is a dispersion having a composition according to Table 1.

**Table 1**

| Component | wt % |
|---|---|
| TiPure R706 | 50 |
| Efka 7701 | 10 |
| Stabilizer | 1 |
| SR285 | 39 |

• Stabilizer is mixture forming a polymerization inhibitor having a composition according to Table 2.

**Table 2**

| Component | wt % |
|---|---|
| DPGDA | 82.4 |
| p-methoxyphenol | 4.0 |
| 2,6-di-tert-butyl-4-methylphenol | 10.0 |
| Cupferron™ AL | 3.6 |

### EXAMPLE 1

The curable compositions COMP-01 to 05 and INV-01 to 05 were prepared to have a composition according to Table 3. The percentages are weight percentages relative to the total weight of the radiaton curable composition.

**Table 3**

| | COMP-01 | INV-01 | COMP-02 | INV-02 | COMP-03 | INV-03 |
|---|---|---|---|---|---|---|
| DISP-01 | 20 | 20 | 20 | 20 | 20 | 20 |
| Genocure LTM | 7 | 7 | 7 | 7 | 7 | 7 |
| Genocure MBF | 3 | 3 | 3 | 3 | 3 | 3 |
| Byk UV 3510 | 1 | 1 | 1 | 1 | 1 | 1 |
| EOEOEA | 20 | - | 20 | - | 20 | - |
| EOEOEMA | - | 20 | - | 20 | - | 20 |
| SR9003 | 30 | 30 | 30 | 30 | - | - |
| CN9001 | 20 | 20 | - | - | - | - |
| CNUVE151 | - | - | 20 | 20 | 20 | 20 |
| EBDA | - | - | - | - | 30 | 30 |

| | COMP-04 | INV-04 | COMP-05 | INV-05 | | |
|---|---|---|---|---|---|---|
| DISP-01 | 20 | 20 | 20 | 20 | | |
| Genocure LTM | 7 | 7 | 7 | 7 | | |
| Genocure MBF | 3 | 3 | 3 | 3 | | |
| Byk UV 3510 | 1 | 1 | 1 | 1 | | |
| EOEOA | 20 | - | 20 | - | | |
| EOEOEMA | - | 20 | - | 20 | | |
| EBDA | 30 | 30 | - | - | | |
| CN976 | 20 | 20 | 20 | 20 | | |
| FST 510 | - | - | 30 | 30 | | |

The curable compositions were coated on a coronized (80W/m²) PET substrate (250 *µ*m) with a bar coater of 20 *µ*m and then UV cured on a Fusion DRSE-120 conveyer using a D bulb (Hg Fe doped lamp) of 600 w/inch at full power and a belt speed of 20 m/min.

The adhesion was evaluated with an Elcometer 1542 cross hatch cutter in accordance with ISO 2409. The results range from 0 (very good adhesion) to 5 (very bad adhesion).

The adhesion was evaluated under normal condition (dry adhesion) and after storing the samples during 500 hours in 85°C and 85 % Relative humidity conditions (adhesion 500 DHT). DHT stands for Damp Heat Test. The results are shown in Table 4.

**Table 4**

| | Dry Adhesion | Adhesion 500 DHT |
|---|---|---|
| COMP-01 | 1 | 5 |
| INV-01 | 1 | 0 |
| COMP-02 | 0 | 4 |
| INV-02 | 1 | 0 |
| COMP-03 | 1 | 5 |
| INV-03 | 1 | 0 |
| COMP-04 | 1 | 5 |
| INV-04 | 1 | 0 |
| COMP-05 | 4 | 5 |
| INV-05 | 1 | 0 |

From the results it is clear that the inventive example all comprising a methacrylate monofunctional monomer (EOEOEMA) have much better adhesion, especially after 500 DHT, compared to the comparative examples comprising an acrylate monofunctional monomer (EOEOEA) .

### EXAMPLE 2

The curable compositions COMP-06 to 10 and INV-06 to 10 were prepared to have a composition according to Table 5. The percentages are weight percentages relative to the total weight of the radiaton curable composition.

**Table 5**

| | COMP-06 | INV-06 | COMP-07 | INV-07 | COMP-08 | INV-08 |
|---|---|---|---|---|---|---|
| DISP-01 | 20 | 20 | 20 | 20 | 20 | 20 |
| Genocure LTM | 7 | 7 | 7 | 7 | 7 | 7 |
| Genocure MBF | 3 | 3 | 3 | 3 | 3 | 3 |
| Byk UV 3510 | 1 | 1 | 1 | 1 | 1 | 1 |
| SR339c | 20 | - | 20 | - | 20 | - |
| SR340 | - | 20 | - | 20 | - | 20 |
| SR9003 | 30 | 30 | 30 | 30 | - | - |
| CN9001 | 20 | 20 | - | - | - | - |
| CNUVE151 | - | - | 20 | 20 | 20 | 20 |
| EBDA | - | - | - | - | 30 | 30 |

| | COMP-09 | INV-09 | COMP-10 | INV-10 | | |
|---|---|---|---|---|---|---|
| DISP-01 | 20 | 20 | 20 | 20 | | |
| Genocure LTM | 7 | 7 | 7 | 7 | | |
| Genocure MBF | 3 | 3 | 3 | 3 | | |
| Byk UV 3510 | 1 | 1 | 1 | 1 | | |
| SR339c | 20 | - | 20 | - | | |
| SR340 | - | 20 | - | 20 | | |
| EBDA | 30 | 30 | - | - | | |
| CN976 | 20 | 20 | 20 | 20 | | |
| Ebecryl 4858 | - | - | 30 | 30 | | |

The curable compositions were coated and cured as described in Example 1.

The adhesion of the cured coatings were evaluated as described in Example 1. The results are shown in Table 6.

**Table 6**

| | Dry Adhesion | Adhesion 500 DHT |
|---|---|---|
| COMP-06 | 5 | - |
| INV-06 | 1 | 0 |
| COMP-07 | 1 | 5 |
| INV-07 | 1 | 0 |
| COMP-08 | 2 | - |
| INV-08 | 1 | 0 |
| COMP-09 | 4 | - |
| INV-09 | 1 | 1 |
| COMP-10 | 5 | - |
| INV-10 | 1 | 0 |

From the results it is clear that the inventive example all comprising a methacrylate monofunctional monomer (SR340 = 2-phenoxyethyl methacrylate) have much better adhesion, especially after 500 DHT, compared to the comparative examples comprising an acrylate monofunctional monomer (SR339c = 2-phenoxyethyl methacrylate).

### EXAMPLE 3

The curable compositions COMP-11 to 14 and INV-11 to 14 were prepared to have a composition according to Table 7. The percentages are weight percentages relative to the total weight of the radiaton curable composition.

**Table 7**

| | COMP-11 | INV-11 | COMP-12 | INV-12 | COMP-13 | INV-13 |
|---|---|---|---|---|---|---|
| DISP-01 | 20 | 20 | 20 | 20 | 20 | 20 |
| Genocure LTM | 7 | 7 | 7 | 7 | 7 | 7 |
| Genocure MBF | 3 | 3 | 3 | 3 | 3 | 3 |
| Byk UV 3510 | 1 | 1 | 1 | 1 | 1 | 1 |
| SR285 | 20 | - | 20 | - | | |
| SR203 | - | 20 | - | 20 | | |
| SR217 | - | - | - | - | 20 | - |
| SR423A | - | - | - | - | - | 20 |
| SR9003 | 30 | 30 | 30 | 30 | 30 | 30 |
| CN976 | 20 | 20 | - | - | - | - |
| CNUVE151 | - | - | 20 | 20 | - | - |
| CN9001 | | | | | 20 | 20 |

| | COMP-14 | INV-14 | | | | |
|---|---|---|---|---|---|---|
| DISP-01 | 20 | 20 | | | | |
| Genocure LTM | 7 | 7 | | | | |
| Genocure MBF | 3 | 3 | | | | |
| Byk UV 3510 | 1 | 1 | | | | |
| SR217 | 20 | - | | | | |
| SR423A | - | 20 | | | | |
| SR9003 | 30 | 30 | | | | |
| CNWE151 | 20 | 20 | | | | |

The curable compositions were coated and cured as described in Example 1.

The adhesion of the cured coatings were evaluated as described in Example 1. The results are shown in Table 8.

**Table 8**

| | Dry Adhesion | Adhesion 500 DHT |
|---|---|---|
| COMP-11 | 1 | 5 |
| INV-11 | 1 | 0 |
| COMP-12 | 0 | 5 |
| INV-12 | 1 | 0 |
| COMP-13 | 4 | 5 |
| INV-13 | 0 | 0 |
| COMP-14 | 4 | 5 |
| INV-14 | 0 | 0 |

From the results it is clear that the inventive examples all comprising a methacrylate monofunctional monomer (SR203 = tetrahydrofurfuryl methacrylate ; SR423a = isobornyl methacrylate) have much better adhesion, especially after 500 DHT, compared to the comparative examples comprising an acrylate monofunctional monomer (SR285 = tetrahydrofurfuryl methacrylate ; SR217 = isobornyl acrylate).

### EXAMPLE 4

The curable compositions COMP-15 to 17 and INV-15 to 19 were prepared to have a composition according to Table 9. The percentages are weight percentages relative to the total weight of the radiaton curable composition.

**Table 9**

| | INV-15 | INV-16 | INV-17 | INV-18 | INV-19 | COMP-15 |
|---|---|---|---|---|---|---|
| DISP-01 | 20 | 20 | 20 | 20 | 20 | 20 |
| Genocure LTM | 7 | 7 | 7 | 7 | 7 | 7 |
| Genocure MBF | 3 | 3 | 3 | 3 | 3 | 3 |
| Byk UV 3510 | 1 | 1 | 1 | 1 | 1 | 1 |
| EOEOEMA | 20 | 20 | 20 | 20 | 20 | 20 |
| SR9003 | 30 | 30 | | | | |
| CN9001 | 20 | | | | | 20 |
| CNUVE151 | | 20 | 20 | | 20 | |
| EBDA | | | 30 | 30 | | |
| CN976 | | | | 20 | | |
| FST510 | | | | | 30 | |
| SR368 | | | | | | 30 |
| | COMP-16 | COMP-17 | | | | |
| DISP-01 | 20 | 20 | | | | |
| Genocure LTM | 7 | 7 | | | | |
| Genocure MBF | 3 | 3 | | | | |
| Byk UV 3510 | 1 | 1 | | | | |
| EOEOEMA | 20 | 20 | | | | |
| SR368 | 30 | 30 | | | | |
| CNUVE151 | 20 | | | | | |
| CN976 | | 20 | | | | |

The curable compositions were coated and cured as described in Example 1.

The adhesion of the cured coatings were evaluated as described in Example 1. The results are shown in Table 10.

**Table 10**

| | Dry Adhesion | Adhesion 500 DHT |
|---|---|---|
| INV-15 | 1 | 0 |
| INV-16 | 1 | 0 |
| INV-17 | 1 | 0 |
| INV-18 | 1 | 0 |
| INV-19 | 1 | 0 |
| COMP-15 | 3 | 5 |
| COMP-16 | 2 | 5 |
| COMP-17 | 3 | 5 |

From the results it is clear that all inventive examples comprising a methacrylate monofunctional monomer (EOEOEMA) in combination with a difunctional (meth)acrylate (SR9003, EBDA, FST510) have a much bettter adhesion, especially after 500 DHT, compared to the comparative examples comprising a methacrylate monofunctional monomer (EOEOEMA) in combination with a trifunctional (meth)acrylate monomer (SR368).

### EXAMPLE 5

The curable compositions COMP-18 to 26 and INV-20 to 24 were prepared to have a composition according to Table 11. The percentages are weight percentages relative to the total weight of the radiaton curable composition.

**Table 11**

| | INV-20 | INV-21 | INV-22 | INV-23 | INV-24 | |
|---|---|---|---|---|---|---|
| DISP-01 | 20 | 20 | 20 | 20 | 20 | |
| Genocure LTM | 7 | 7 | 7 | 7 | 7 | |
| Genocure MBF | 3 | 3 | 3 | 3 | 3 | |
| Byk UV 3510 | 1 | 1 | 1 | 1 | 1 | |
| SR340 | 20 | 20 | 20 | 20 | 20 | |
| SR9003 | 30 | 30 | | | | |
| CN9001 | 20 | | | | | |
| CNUVE151 | | 20 | 20 | | | |
| EBDA | | | 30 | 30 | | |
| CN976 | | | | 20 | 20 | |
| Ebecryl 4858 | | | | | 30 | |
| | | | | | | |

| | COMP-18 | COMP-19 | COMP-20 | COMP-21 | COMP-22 | COMP-23 |
|---|---|---|---|---|---|---|
| DISP-01 | 20 | 20 | 20 | 20 | 20 | 20 |
| Genocure LTM | 7 | 7 | 7 | 7 | 7 | 7 |
| Genocure MBF | 3 | 3 | 3 | 3 | 3 | 3 |
| Byk UV 3510 | 1 | 1 | 1 | 1 | 1 | 1 |
| SR340 | 20 | 20 | 20 | 20 | 20 | 20 |
| SR351 | 30 | 30 | 30 | | | |
| CN9001 | 20 | | | 20 | | |
| CNUVE151 | | 20 | | | 20 | |
| CN976 | | | 20 | | | 20 |
| Miramer M600 | | | | 30 | 30 | 30 |

| | COMP-24 | COMP-25 | COMP-26 | | | |
|---|---|---|---|---|---|---|
| DISP-01 | 20 | 20 | 20 | | | |
| Genocure LTM | 7 | 7 | 7 | | | |
| Genocure MBF | 3 | 3 | 3 | | | |
| Byk UV 3510 | 1 | 1 | 1 | | | |
| SR340 | 20 | 20 | 20 | | | |
| SR368 | 30 | 30 | 30 | | | |
| CN9001 | 20 | | | | | |
| CNUVE151 | | 20 | | | | |
| CN976 | | | 20 | | | |

The curable compositions were coated and cured as described in Example 1.

The adhesion of the cured coatings were evaluated as described in Example 1. The results are shown in Table 12.

**Table 12**

| | Dry Adhesion | Adhesion 500 DHT |
|---|---|---|
| INV-20 | 1 | 0 |
| INV-21 | 1 | 0 |
| INV-22 | 1 | 0 |
| INV-23 | 1 | 0 |
| INV-24 | 1 | 0 |
| COMP-18 | 3 | - |
| COMP-19 | 4 | - |
| COMP-20 | 1 | 5 |
| COMP-21 | 3 | - |
| COMP-22 | 1 | 5 |
| COMP-23 | 1 | 5 |
| COMP-24 | 5 | - |
| COMP-25 | 1 | 5 |
| COMP-26 | 2 | 5 |

From the results it is clear that all inventive examples comprising a methacrylate monofunctional monomer (SR340) in combination with a difunctional (meth)acrylate (SR9003, EBDA, Ebecryl 4858) have a much bettter adhesion, especially after 500 DHT, compared to the comparative examples comprising a methacrylate monofunctional monomer (SR340) in combination with a trifunctional (meth)acrylate monomer (SR351, SR368) or a hexafunctional (meth)acrylate (Miramer M600).

### EXAMPLE 6

The curable compositions COMP-27 to 30 and INV-25 to 28 were prepared to have a composition according to Table 13. The percentages are weight percentages relative to the total weight of the radiaton curable composition.

**Table 13**

| | INV-25 | INV-26 | COMP-27 | COMP-28 | INV-27 | INV-28 |
|---|---|---|---|---|---|---|
| DISP-01 | 20 | 20 | 20 | 20 | 20 | 20 |
| Genocure LTM | 7 | 7 | 7 | 7 | 7 | 7 |
| Genocure MBF | 3 | 3 | 3 | 3 | 3 | 3 |
| Byk UV 3510 | 1 | 1 | 1 | 1 | 1 | 1 |
| SR203 | 20 | 20 | 20 | 20 | | |
| SR423A | | | | | 20 | 20 |
| SR9003 | 30 | 30 | | | 30 | 30 |
| CNUVE151 | 20 | | 20 | | | 20 |
| CN976 | | 20 | | 20 | | |
| SR368 | | | 30 | 30 | | |
| CN9001 | | | | | 20 | |

| | COMP-29 | COMP-30 | | | | |
|---|---|---|---|---|---|---|
| DISP-01 | 20 | 20 | | | | |
| Genocure LTM | 7 | 7 | | | | |
| Genocure MBF | 3 | 3 | | | | |
| Byk UV 3510 | 1 | 1 | | | | |
| SR423A | 20 | 20 | | | | |
| SR368 | 30 | 30 | | | | |
| CNUVE151 | 20 | | | | | |
| CN976 | | 20 | | | | |

The curable compositions were coated and cured as described in Example 1.

The adhesion of the cured coatings were evaluated as described in Example 1. The results are shown in Table 14.

**Table 14**

| | Dry Adhesion | Adhesion 500 DHT |
|---|---|---|
| INV-25 | 1 | 0 |
| INV-26 | 1 | 0 |
| COMP-27 | 4 | 5 |
| COMP-28 | 3 | 5 |
| INV-27 | 0 | 0 |
| INV-28 | 0 | 0 |
| COMP-29 | 3 | 5 |
| COMP-30 | 3 | 5 |

From the results it is clear that the inventive example all comprising a methacrylate monofunctional monomer (SR203 = tetrahydrofurfuryl methacrylate ; SR423A = isobornyl methacrylate) have much better adhesion, especially after 500 DHT, compared to the comparative examples comprising an acrylate monofunctional monomer (SR339c = 2-phenoxyethyl methacrylate).

From the results it is clear that all inventive examples comprising a methacrylate monofunctional monomer (SR203 = tetrahydrofurfuryl methacrylate ; SR423A = isobornyl methacrylate) in combination with a difunctional (meth)acrylate (SR9003 = ) have a much bettter adhesion, especially after 500 DHT, compared to the comparative examples comprising a methacrylate monofunctional monomer (SR203 or SR423A) in combination with a trifunctional (meth)acrylate monomer (SR368).

## Claims

1. A backsheet (1) for a photovoltaic module (5) comprising a support (10) and a weather resistant outerlayer provided on a side of the support **characterized in that** the weather resistant outerlayer comprises an at least partially cured coating from a curable composition wherein the curable composition comprises a monofunctional methacrylate monomer and a difunctional (meth)acrylate monomer.

2. The backsheet according to claim 1 wherein the amount of monofunctional methacrylate monomer is between 10 and 30 wt %.

3. The backsheet according to claim 1 or 2 wherein the amount of difunctional (meth)acrylate is between 20 and 40 wt %.

4. The backsheet according to any of the preceding claims wherein the monofunctional methacrylate is selected from the group consisting of a tetrahydrofurfurylmethacrylate, a phenoxyethylmethacrylate, ethoxyethoxymethacrylate and isobornylmethacrylate.

5. The backsheet according to any of the preceding claims wherein the difunctional (meth)acrylate is a propoxylated neopentyl glycoldiacrylate.

6. The backsheet according to any of the preceding claims wherein the curable composition further comprises an oligomer.

7. The backsheet according to claim 6 wherein the oligomer is selected from the group consisting of aromatic polyurethane acrylates, aliphatic urethane acrylates and aromatic epoxy acrylates.

8. The backsheet according to any of the preceding claims wherein the curable composition further comprises an UV absorber.

9. The backsheet according to claim 8 wherein the UV absorber is an inorganic pigment.

10. The backsheet according to claim 9 wherein the inorganic pigment is Ti0₂ or Zn0.

11. The backsheet according to claim 9 or 10 wherein the amount of inorganic pigment is from 5 to 15 g/m²

12. The backsheet according to any of the preceding claims wherein the support is surface treated on the side whereupon the weather resistant layer is applied.

13. The backsheet according to any of the preceding claims wherein a primer (11) is applied on the side of the support facing the encapsulant layer (2').

14. A method for preparing a backsheet (1) for a photovoltaic module (5) comprising the steps of:
- providing a support;
- applying a curable composition on one side of the support; and
- at least partially curing the applied curable composition; **characterized in that** the curable composition comprises a monofunctional methacrylate and a difunctional (meth)acrylate.

15. The method according to claim 14 wherein curing is carried out by UV radiation or electron beam radiation.
